**Europäisches Patentamt**

**European Patent Office**

**Office européen des brevets**

(19)

(11) Veröffentlichungsnummer: **0 450 106 A1**

(12) # EUROPÄISCHE PATENTANMELDUNG

(21) Anmeldenummer: **90106137.4**

(22) Anmeldetag: **30.03.90**

(51) Int. Cl.5: **H01L 21/285**

(43) Veröffentlichungstag der Anmeldung:
**09.10.91 Patentblatt 91/41**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Körner, Heinrich, Dr.-Dipl.-Chem.**
**Föhrenstrasse 17b**
**W-8206 Bruckmühl(DE)**
Erfinder: **Treichel, Helmuth, Dipl.-Ing. (FH)**
**Weldishoferstrasse 4**
**W-8900 Augsburg(DE)**
Erfinder: **Hieber, Konrad, Dr.-Dipl.-Phys.**
**Am Herrenholz 10**
**W-8011 Grasbrunn(DE)**

(54) **Verfahren und Vorrichtung zur Herstellung einer Titannitrid-Schicht für höchstintegrierte Schaltungen mittels chemischer Dampfphasenabscheidung.**

(57) Zur Herstellung von Titannitrid-Schichten, die als Haft-, Kontakt- und Barriere-Schichten in höchstintegrierten Schaltungen verwendet werden, wird ein chemischer Dampfphasenabscheideprozeß in einer Mehrkammer-Hochvakuumanlage eingesetzt, wobei durch die Wahl einer stickstoffhaltigen organischen Titan-Verbindung als Ausgangssubstanz und den Einsatz von thermischer, optischer und/oder Plasma-Anregung eine Schichtabscheidung auch bei niedrigen Temperaturen im Bereich 200 - 550 °C ermöglicht wird. Die erhaltenen Schichten zeichnen sich durch eine hohe Kantenbedeckung auch bei engen Kontaktlöchern sowie durch gute elektrische und chemische Eigenschaften aus. Eine erfindungsgemäße Vorrichtung zur Durchführung des Verfahrens besteht aus einer Mehrkammer-Hochvakuumanlage, deren Kammern (1 - 6) durch Hochvakuumschleusen (7) verbunden sind, so daß eine besonders vorteilhafte Kombination mehrerer, unterschiedlicher Prozesse ohne Unterbrechung der Hochvakuum-Bedingungen möglich ist.

EP 0 450 106 A1

Rank Xerox (UK) Business Services

Die Erfindung betrifft ein Verfahren zur Herstellung einer Titannitrid-Schicht für höchstintegrierte Schaltungen nach dem Oberbegriff des Patentanspruchs 1, sowie eine Vorrichtung zur Durchführung des Verfahrens.

Titannitrid-Schichten werden für integrierte Schaltungen in der Halbleitertechnologie, insbesondere bei Verwendung von Silizium als Halbleitersubstrat, zu mehreren Zwecken eingesetzt:

1. als Diffusionsbarriere

Werden Silizium oder Polysilizium enthaltende Halbleitersubstrate mit Hilfe von Aluminiumleitbahnen kontaktiert, tritt aufgrund der Löslichkeit von Silizium in Aluminium das sog. "Spiking" auf, d. h. Silizium diffundiert in die Aluminiumleitbahn und scheidet sich später wieder aus. Diese Ausscheidungen im Aluminium sowie der damit verbundene Materialverlust im Siliziumsubstrat können zu einer Schwächung des elektrischen Kontaktes führen, insbesondere, wenn der Spiking-Effekt im Bereich kleinster Strukturen, z. B. in den sog. Kontaktlöchern auftritt. Es ist Stand der Technik, die Interdiffusion von Silizium und Aluminium dadurch zu verhindern, daß eine Diffusionsbarriere z. B. aus Titannitrid oder Titan/Wolfram zwischen das Substrat und die Leitbahn mindestens im Kontaktloch eingebracht wird. Da diese Schichten wesentlich schlechter leiten als die Aluminiumleitbahn, wird angestrebt, ihre Dicke möglichst gering zu halten, gleichzeitig müssen sie aber eine ausreichende Barrierewirkung sicherstellen. Eine gleichmäßige und genügende Bedeckung der Seitenwände des Kontaktloches durch die Barriereschicht ist auch deshalb wünschenswert, da sie hier im Bedarfsfall die Stromleitung mit übernimmt.

2. zur Verbesserung der elektrischen Eigenschaften von Leitbahnen

Mit Hilfe einer Titannitrid-Schicht kann die bevorzugte Ausbildung einer (111)-Textur in den nachfolgend aufgebrachten Aluminiumschichten gefördert werden, wodurch deren Stabilität und Elektromigrationsresistenz erhöht wird. Dem gleichen Zweck dienen dünne Titannitrid-Schichten, die zusätzlich in oder auf Aluminiumleitbahnen aufgebracht werden; diese Maßnahme unterdrückt ferner die Ausbildung unerwünschter Materialschwachstellen im Aluminium (beispielsweise Hillocks).

3. als Haft- und Barriereschicht bei mit Wolfram gefüllten Kontaktlöchern

In dieser Anwendung wird mit der zwischenliegenden Titannitrid-Schicht die Haftung des Wolfram an der unterliegenden Schicht verbessert. Außerdem schützt sie die freiliegenden Silizium- oder Aluminiumflächen vor dem chemischen Angriff reaktiver Fluorverbindungen, die bei üblichen Wolframabscheideprozessen freigesetzt werden. Die Reaktion mit den freiliegenden Flächen würde zur Bildung von Fluorverbindungen führen, die den elektrischen Übergangswiderstand beeinflussen.

Um die Anforderungen bei den genannten Anwendungen zu erfüllen, muß ein Herstellverfahren für Titannitrid-Schichten zu einer homogenen, dichten, defektfreien Schicht führen und eine gute Kantenbedeckung auch bei Kontaktlöchern mit einem Aspektverhältnis A (A = Tiefe des Kontaktloches/Durchmesser) $\geq$ 1 aufweisen.

Folgende Herstellverfahren für Titannitrid-Schichten sind bekannt:

1. Physikalisches Aufstäuben (Sputtern)

Ein solches Verfahren ist beispielsweise in EP-A-0 280 089 näher beschrieben und dann anwendbar, wenn die zu beschichtende Oberfläche Strukturen mit Aspektverhältnissen A < 1 aufweist. Wi bei physikalischen Aufstäubtechniken üblich, weist es jedoch als Nachteile eine schlechte Kantenbedeckung insbesondere bei Aspektverhältnissen A $\geq$ 1 und eine mangelnde Konformität der abgeschiedenen Schichten auf. Um eine ausreichend dicke Titannitrid-Schicht auf dem Boden eines engen Kontaktloches zu erreichen, müßte daher eine sehr viel dickere Schicht (über 100 nm) auf horizontalen Flächen abgeschieden werden, was aus den oben ausgeführten Gründen vermieden werden sollte. Bei Strukturen mit Aspektverhältnissen A $\geq$ 1 ist es nicht mehr anwendbar. Weitere mit diesem Verfahren verbundene Nachteile sind:

a) Die hohe Anzahl an losen, aus dem Sputtertarget oder aus sonstigen Teilen während des Prozesses herausgeschlagenen Partikeln kann zu Kurzschlüssen in der zu fertigenden Halbleiterschaltung führen.

b) Eine ausreichende Barrierewirkung dieser Schichten entwickelt sich erst dann, wenn die Schichten bei erhöhter Temperatur mit Luft in Kontakt gebracht werden. Durch die dabei erfolgende partielle Oxidation, die bevorzugt an den Korngrenzen des aufgestäubten Titannitrids stattfindet, wird die Interdiffusion von Silizium und Aluminium unterdrückt. Dieser notwendige Oxidationsschritt vergrößert jedoch die Gefahr weiterer Kontaminationen und die Produktionsdurchlaufzeiten und verhindert insbesondere eine Integration mit anderen Prozessen, bspw. eine direkt anschließende Abscheidung der Aluminiumschicht in derselben Hochvakuumanlage.

c) Mit einem Sputterprozeß ist es im allgemeinen nicht möglich, eine Titannitrid-Schicht mit niedrigen mechanischen Spannungen (sog. Streß) und gleichzeitig hoher Barrierenqualität abzuscheiden, wie es für die genannten Anwendungen notwendig wäre. Dies ist beispielsweise in dem Artikel von S. Kanamori in Thin Solid Films, 136 (1986), Seite 195 bis 214 eingehend erläutert.

d) Um einen reproduzierbaren und niederohmigen Kontakt zum Siliziumsubstrat zu gewährleisten, muß bei diesem Verfahren vor der Titannitrid-Abscheidung zusätzlich eine etwa 20 nm dicke metallische Schicht, beispielsweise aus Titan, abgeschieden werden.

2. Chemische Dampfphasenabscheidung (CVD)

Dieses in dem Artikel von N. Yokohama et al. in Journal of Electrochemical Society 136, Nr. 3 (1989), Seiten 882 bis 883 näher beschriebene Verfahren setzt als Ausgangssubstanzen Titanchlorid und Ammoniak ein und wurde bisher überwiegend zur Anwendung in der Hartstoffbeschichtung untersucht. Gegenüber dem Aufstäubverfahren zeichnet es sich bei geeigneter Wahl der Abscheidebedingungen durch eine wesentlich bessere Kantenbedeckung auch bei kleinsten Strukturen aus; in der Mikroelektronik ist es jedoch aufgrund folgender Nachteile nur sehr bedingt einsetzbar:

a) Die notwendigen relativ hohen Abscheidetemperaturen von 500 bis 700° C können zum einen zu einer verstärkten Oxidation der Siliziumoberfläche führen und damit zu stark erhöhten elektrischen Übergangswiderständen. Zum anderen machen sie die Anwendung des Verfahrens bei Substraten, die bereits eine Aluminiumschicht aufweisen, unmöglich, da hier bei Prozeßtemperaturen über 450° C Materialveränderungen wie z. B. Hillockbildung auftreten.

b) In die abgeschiedene Schicht werden Chlor und Wasserstoff eingebaut, wodurch die elektrischen Eigenschaften, die Materialdichte und damit die Barrierenqualität der Schicht negativ verändert werden.

c) Durch die verwendeten chlorhaltigen Ausgangssubstanzen werden Pumpen, Abscheidekammer und Schichten angegriffen und beeinträchtigt, sowie erhöhte Anforderungen an die Prozeßsicherheit gestellt.

Der Erfindung liegt daher die Aufgabe zugrunde, ein Herstellverfahren für Titannitrid-Schichten als Kontakt-, Barriere- oder Haftschicht in höchstintegrierten Schaltungen anzugeben, das sich durch Einfachheit und Eliminierung von gefährlichen oder korrosiven Ausgangssubstanzen auszeichnet, die Herstellung bei Temperaturen deutlich unterhalb 450° C ermöglicht und eine Integration mit vorausgehenden oder nachfolgenden Prozessen erlaubt. Die mit diesem Verfahren abgeschiedenen Schichten sollen gleichmäßig, dicht und defektfrei sein und geringe mechanische Spannungen, eine gute Haftung zu unterliegenden Schichten und eine hohe Kantenbedeckung auch bei Strukturen mit einem Aspektverhältnis $A \geq 1$ aufweisen.

Diese Aufgabe wird durch die kennzeichnenden Merkmale des Patentanspruchs 1 gelöst. Weiterbildungen der Erfindung, insbesondere eine Vorrichtung zur Durchführung des Verfahrens, sind Gegenstand von Unteransprüchen.

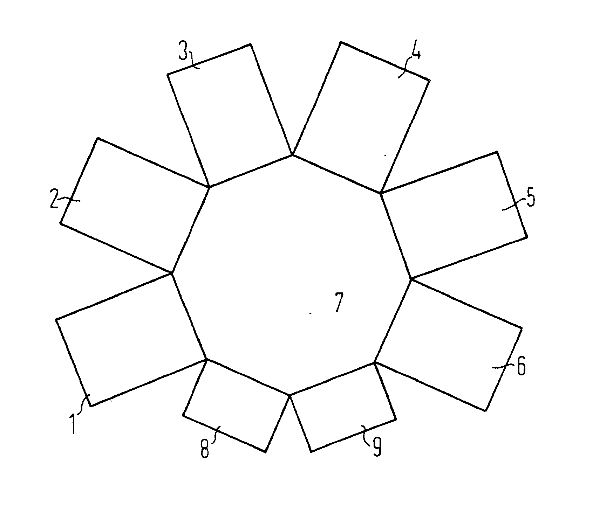

FIG 1 zeigt eine Ausführungsform der Vorrichtung in schematischer Darstellung.

In dem Artikel von k. Sugiyama in Electrochem. Soc. 122, Nr. 11 (1975), S. 1545 bis 1549 wird zwar ein Herstellverfahren für Titannitrid-Schichten unter Verwendung einer stickstoffhaltigen organischen Titan-Verbindung angegeben, dieses CVD-Verfahren benötigt aber ebenfalls Prozeßtemperaturen von etwa 400° C, um befriedigende Ergebnisse zu liefern. Für die Anwendung bei höchstintegrierten Schaltungen ist das Verfahren nicht vorgesehen und auch nicht geeignet, da es zum einen keine gleichmäßigen Schichten liefert, zum anderen die abgeschiedenen Titannitrid-Schichten einen um den Faktor $10^4$ größeren Schichtwiderstand als mit bekannten Verfahren hergestelltes Titannitrid aufweisen. Im Gegensatz zum erfindungsgemäßen Verfahren ist ferner nur eine thermische Anregung der Ausgangssubstanzen ohne Einsatz eines Reduktionsmittels vorgesehen.

Die vorliegende Erfindung löst das Problem, Titannitrid-Schichten mit den für die genannten Anwendungen erforderlichen Eigenschaften wie Konformität, Streßarmut, gute Kantenbedeckung, hohe Barrierewirkung, gute Leitfähigkeit und andere auch bei niedrigen Temperaturen herzustellen durch die Verwendung von Ausgangssubstanzen, die sowohl Titan als auch Stickstoff bereits in einem Molekül enthalten und im folgenden als stickstoffhaltige organische Titan-Verbindungen bezeichnet werden, und durch den Einsatz von thermischer oder optischer Anregung oder Anregung im elektromagnetischen Wechselfeld (sog. Plasmaanregung) oder einer beliebigen Kombination dieser Anregungsarten. Als Ausgangssubstanzen kommen beispielsweise Vertreter folgender Substanzklassen in Betracht:

1. $Ti(NR_2)_4$ mit R = Alkyl, Aryl, $CF_3$

2. $Ti(NHR)_4$ mit R = Alkyl, Aryl, $CF_3$

3. $Ti(NR_2)_2R'_2$ mit R = Alkyl und R' = Alkyl, Aryl, $CF_3$

Erfindungsgemäß kann das Titan-Stickstoff-Verhältnis und die Struktur der abgeschiedenen Titannitrid-Schicht in der Nahordnung sowohl durch geeignete Wahl der Ausgangsverbindung, durch Modifikation des Restes R, R', als auch durch Variation der Parameter des Abscheideprozesses sowie einen eventuellen Zusatz von gasförmigem Stickstoff oder Ammoniak eingestellt werden.

Die Konformität und damit eine gute Kantenbedeckung auch in engen Strukturen wird dadurch erreicht, daß ein als oberflächenkontrollierte Reaktion ablaufender Abscheideprozeß eingesetzt wird. Dies gelingt durch die Wahl eines ausreichend hohen und stationären Partialdrucks der stickstoffhaltigen organischen Titan-Verbindung (d. h., die Rate des Antransports dieser Verbindung ist sehr viel größer als die Rate des Verbrauchs durch die Umsetzung) und durch die Wahl geeigneter Reduktionsmittel wie $H_2$ und $NH_3$. Diese beiden Moleküle zerfallen bevorzugt an metallischen und metallähnlichen Oberflächen unter Bildung von besonders reaktivem, atomaren Wasserstoff, welcher wiederum die Zersetzung der stickstoffhaltigen organischen Titan-Verbindung direkt an der Oberfläche ermöglicht. Diese Reaktion erfolgt bereits bei Prozeßtemperaturen von etwa 200° C.

Erfindungsgemäß kann die Ausgangssubstanz auch optisch oder durch ein Plasma bei Raumtemperatur angeregt werden. Die Kombination von thermischer Anregung mit einer weiteren Anregungsart, beispielsweise durch ein Plasma, ist vorteilhaft, um bspw. bei einer vorgewählten Prozeßtemperatur eine höhere Abscheiderate zu erzielen. Auf den Zusatz eines Reduktionsmittels kann verzichtet werden.

Für die Durchführung des erfindungsgemäßen Verfahrens ist der Einsatz einer Hochvakuum-Anlage, die gemäß der in FIG 1 dargestellte Ausführungsform insbesondere mehrere Hochvakuum-Kammern 1 - 6 für eventuell unterschiedliche Prozesse und eine diese Kammern verbindende Hochvakuum-Schleuse 7 aufweist, besonders vorteilhaft, da dann, wie noch genauer erläutert wird, mehrere, günstig kombinierbare Prozesse direkt hintereinander ausgeführt werden können, ohne daß die Hochvakuum-Bedingungen unterbrochen werden müssen. Die zu beschichtenden Halbleitersubstrate, meist Silizium-Wafer mit bereits teilweise fertiggestellten Schaltungen, werden aus mindestens einer Vorratskammer 8, 9 entnommen bzw. in diese abgelegt.

Die mit den erfindungsgemäßen Verfahren abgeschiedenen Titannitrid-Schichten zeichnen sich, im Gegensatz zu den mit bekannten Verfahren erzeugten Schichten, bereits unmittelbar nach der Abscheidung durch eine wesentlich bessere Barrierewirkung aus. Diese wird unter anderem durch den Einbau von Kohlenstoff begründet, wodurch die Schichten in sich die bekannten, vorteilhaften Barrierewirkungen von Titannitrid und Titancarbid vereinigen. Dadurch ist es insbesondere nicht notwendig, zur Verbesserung der Barrierewirkung die Schichten durch Luftkontakt partiell zu oxidieren, wie dies beim Aufstäubverfahren der Fall ist. Die erfindungsgemäß hergestellten Titannitrid-Schichten weisen außerdem eine dichte, porenärmere Struktur auf und bieten dadurch weniger Diffusionspfade. Durch geeignete Wahl der Parameter des Abscheideprozesses können Schichten mit minimalen mechanischen Spannungen bei gleichzeitig dichtem, polykristallinem Gefüge erzeugt werden, wodurch die Zuverlässigkeit als Barriereschicht steigt, die Haftung der Titannitrid-Schicht selbst verbessert und die Kompatibilität mit anderen Schichten erhöht wird. Aufgrund dieser verbesserten Schichteigenschaften ist eine Integration des Verfahrens mit anderen vorausgehenden oder nachfolgenden Prozessen in derselben Hochvakuumanlage möglich; hierin liegt ein besonderer Vorteil gegenüber allen bekannten Verfahren.

Das Verfahren weist gegenüber dem Stand der Technik wesentliche Vorteile auf:

Durch den Verzicht auf gefährliche oder korrosive Ausgangsverbindungen wird gegenüber üblichen CVD-Verfahren die Verfahrensweise erheblich erleichtert, die Lebensdauer der eingesetzten Geräte verlängert und eine hohe Sicherheit gewährleistet.

Durch Ausführung des Verfahrens in einer Anlage, die aus einer hochvakuumdichten Schleuse 7 und mindestens einer hochvakuumdichten Abscheidekammer 1 - 6 besteht, wird eine Reoxidation der Silizium-Oberfläche vor der Abscheidung vermieden, die Feuchtigkeitsaufnahme der Schichten verringert und dadurch ihre Haftung und der Übergangswiderstand zum unterliegenden Silizium verbessert. Ferner wird dadurch und durch die oben erläuterten verbesserten Schichteigenschaften die In-Situ-Integration des Verfahrens mit vorausgehenden und/oder nachfolgenden Verfahrensschritten ermöglicht, insbesondere wenn eine Hochvakuumanlage mit mehreren, auch für verschiedene Prozesse einsetzbaren Kammern verwendet wird. Ohne Unterbrechung der Hochvakuumbedingungen sind beispielsweise folgende Verfahrenskombinationen möglich: Vorhergehendes Abscheiden einer beispielsweise aus Titan bestehenden metallischen Kontaktschicht in Kammer 1, erfindungsgemäßes Abscheiden einer Titannitrid-Schicht in Kammer 2, anschließender Temperatur-Schritt in Kammer 3 und/oder Aufbringen einer weiteren Schicht wie Wolfram zur Auffüllung von Kontaktlöchern oder einer sonstigen leitenden oder nicht leitenden Schicht in evt. weiteren Kammern 4 - 6. Solche und andere Prozeßkombinationen führen einerseits zu verbesserten

4

Eigenschaften der Schaltungen, beispielsweise zu niedrigeren und reproduzierbareren Kontaktwiderständen, und andererseits zu erhöhter Prozeßsicherheit und geringeren Bearbeitungszeiten.

Das Verfahren ermöglicht insbesondere durch die Wahl der Ausgangssubstanzen und evt. unterstützt durch nicht-thermische Anregungen, Titannitrid-Abscheidungen bei Temperaturen deutlich unterhalb von 450° C vorzunehmen. Dadurch kann es auch eingesetzt werden, wenn die zu beschichtenden Substrate bereits Aluminium aufweisen.

Ausführungsbeispiel:

Für das erfindungsgemäße Verfahren wird eine in FIG 1 dargestellte Hochvakuum-Anlage mit mehreren Kammern 1 - 6 und einer Hochvakuumschleuse 7 eingesetzt, die beispielsweise bei einer Leckrate unter $5 \times 10^{-6}$ mbar $\times 1 \times s^{-1}$ einen Basisdruck unterhalb von $5 \times 10^{-7}$ mbar erreicht. Ein zu beschichtendes Halbleitersubstrat, insbesondere ein sogenannter Silizium-Wafer mit bereits teilweise hergestellten integrierten Schaltungen, wird aus einer Vorratskammer 8, 9 in eine für CVD-Prozesse geeignete Kammer 2 gebracht. Diese Kammer besitzt vorteilhafterweise ferner mindestens zwei Elektroden zur Erzeugung eines Plasmas sowie eine Vorrichtung, die eine optische Anregung von eingeleiteten Gasen ermöglicht, beispielsweise ein entsprechendes Fenster. Eine stickstoffhaltige organische Titan-Verbindung aus einer der bereits erwähnten Substanzklassen und mit einer Verdampfertemperatur im Bereich von 25 bis 120° C wird mittels eines Trägergases (z. B. $H_2$, $N_2$, He) oder durch Einsaugen in die Kammer eingebracht. Ferner können als Prozeßgase $H_2$, $N_2$ und $NH_3$ in die Kammer eingeleitet werden. Die Abscheidung der Titannitrid-Schicht erfolgt im Temperaturbereich von 200 bis 550° C bei einem Druck von 0,1 bis 100 mbar unter Einsatz mindestens einer der bereits erwähnten Anregungsarten.

Beispielsweise kann Ti $[N(CH_3)_2]_4$ als stickstoffhaltige organische Titan-Verbindung aus der Substanzklasse 1 thermisch zersetzt werden mit $H_2$ und/oder $NH_3$ als Reduktionsmittel:

$$2 \text{ Ti } [N(cH_3)_2]_4 + 3H_2 \rightarrow 2 \text{ TiN} + 6 \text{ HN}(CH_3)_2 + 2C_2H_6$$

Durch Zugabe von $N_2$ oder $NH_3$ kann die Abscheidung einer Titanreichen Titannitrid-Schicht unterdrückt werden.

Als weitere Ausführungsformen kann anstelle oder zusätzlich zur thermischen Anregung eine Plasmaanregung durch Zünden eines Plasmas zwischen den beiden Elektroden eingesetzt werden oder eine optische Anregung der stickstoffhaltigen organischen Titan-Verbindung, mit der beispielsweise gezielt die N-C-Bindung gespalten wird.

Die Parameter für den Abscheideprozeß liegen bei den genannten Ausführungsformen in den folgenden Bereichen:

| | | | |
|---|---|---|---|
| Temperatur | : | 200-550 | °C |
| Druck | : | 0.1-133 | mbar |
| RF-Leistung der Plasmaanregung | : | 0-800 W | |
| Elektrodenabstand | : | 0.3-1,5 | cm |
| Trägergasfluß | : | 0-600 | sccm $N_2$, $H_2$ bzw. He |
| $N_2$- bzw. $NH_3$-Fluß | : | 0-300 | sccm |
| $H_2$-Fluß | : | 100-1000 | sccm |
| Verdampfungstemperatur | : | 25-120 | °C |
| Abscheiderate | : | 500 nm/min. | |

**Patentansprüche**

1. Verfahren zur Herstellung einer Titannitrid-Schicht für höchtingegrierte Schaltungen mittels chemischer Dampfphasenabscheidung in einer Hochvakuumkammer,
   **dadurch gekennzeichnet,**
   daß als Ausgangssubstanz eine stickstoffhaltige organische Titan-Verbindung eingesetzt wird, welche thermisch angeregt wird, und Wasserstoff und/oder Ammoniak als Reduktionsmittel zugegeben wird.

2. Verfahren zur Herstellung einer Titannitrid-Schicht für höchtingegrierte Schaltungen mittels chemischer Dampfphasenabscheidung in einer Hochvakuumkammer,
**dadurch gekennzeichnet,**
daß als Ausgangssubstanz eine stickstoffhaltige organische Titan-Verbindung eingesetzt wird, welche optisch oder durch ein Plasma angeregt wird oder durch eine Kombination mindestens einer dieser Anregungsarten mit thermischer Anregung.

3. Verfahren nach Anspruch 2,
**gekennzeichnet** durch eine Zugabe von Wasserstoff und/oder Ammoniak als Reduktionsmittel.

4. Verfahren nach einem der Ansprüche 1 bis 3,
**dadurch gekennzeichnet,**
daß die stickstoffhaltige organische Titan-Verbindung aus einer der folgenden Substanzklassen ausgewählt wird:
$Ti(NR_2)_4$ mit R = Alkyl, Aryl, $CF_3$
$Ti(NHR)_4$ mit R = Alkyl, Aryl, $CF_3$
$Ti(NR_2)R'_2$ mit R = Alkyl und R' = Alkyl, Aryl, $CF_3$

5. Verfahren nach einem der Ansprüche 1 bis 4,
**dadurch gekennzeichnet,**
daß die Abscheidung bei einer Temperatur im Bereich von 200 bis 550°C durchgeführt wird.

6. Verfahren nach einem der Ansprüche 1 bis 5,
**gekennzeichnet** durch eine Zugabe von Stickstoff und/oder Ammoniak.

7. Verfahren nach einem der Ansprüche 1 bis 6,
**dadurch gekennzeichnet,**
daß mechanische, elektrische oder chemische Eigenschaften der abgeschiedenen Titannitrid-Schicht durch Auswahl der stickstoffhaltigen organischen Titan-Verbindung und/oder geeigneter Prozeßparameter eingestellt werden.

8. Verfahren nach einem der Ansprüche 2 bis 7,
**gekennzeichnet** durch eine optische Anregung der stickstoffhaltigen organischen Titan-Verbindung zur gezielten Spaltung der Stickstoff-Kohlenstoff-Bindung.

9. Verfahren nach einem der Ansprüche 1 bis 8,
**gekennzeichnet** durch die Auswahl der Prozeßparameter innerhalb folgender Bereiche:

```
Temperatur                        :    200-550    °C
Druck                             :    0,1-133    mbar
RF-Leistung der Plasmaanregung    :    0-800 W
Elektrodenabstand                 :    0,3-1,5    cm
Trägergasfluß                     :    0-600      sccm N₂, H₂ bzw.He
N₂- bzw. NH₃-Fluß                 :    0-300      sccm
H₂-Fluß                           :    100-1000   sccm
Verdampfungstemperatur            :    25-120     °C
Abscheiderate                     :    ≲ 500 nm/min.
```

10. Verfahren nach einem der Ansprüche 1 bis 9,
**gekennzeichnet** durch eine direkt vorausgehende Abscheidung einer leitenden Schicht unter Aufrechterhaltung der Hochvakuum-Bedingung für das Halbleitersubstrat.

11. Verfahren nach einem der Ansprüche 1 bis 10,
    **gekennzeichnet** durch eine direkt anschließende Abscheidung einer leitenden oder nicht leitenden Schicht unter Aufrechterhaltung der Hochvakuum-Bedingung für das Halbleitersubstrat.

12. Vorrichtung zur Durchführung des Verfahrens nach einem der Ansprüche 1 bis 11, bestehend aus einer Mehrkammer-Hochvakuum-Anlage, deren Kammern (1-6) durch eine Hochvakuum-Schleuse (7) verbunden sind und die Kombination mehrerer, unterschiedlicher Prozesse ohne Unterbrechung der Hochvakuum-Bedingungen ermöglichen.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 174 743 (MORTON THIOKOL) * Spalte 3, Zeile 1 - Spalte 4, Zeile 44; Spalte 5, Zeile 25 - Spalte 6, Zeile 45 * --- | 1-8 | H 01 L 21/285 |
| D,A | JOURNAL ELECTROCHEM. SOC.: SOLID-STATE SCIENCE AND TECHNOLOGY, Band 122, Nr. 11, November 1975, Seiten 1545-1549; K. SUGIYAMA et al.: "Low temperature deposition of metal nitrides by thermal decomposition of organometallic compounds" * Zusammenfassung * ----- | 1-9 | |

RECHERCHIERTE SACHGEBIETE (Int. Cl.5)

H 01 L
C 23 C

~~Der vorliegende Recherchenbericht wurde für alle Patentansprüche erstellt~~

| Recherchenort | Abschlußdatum der Recherche | Prüfer |
|---|---|---|
| DEN HAAG | 24-10-1990 | GORI P. |

Europäisches
Patentamt

---

## GEBÜHRENPFLICHTIGE PATENTANSPRÜCHE

Die vorliegende europäische Patentanmeldung enthielt bei ihrer Einreichung mehr als zehn Patentansprüche.

☐ Alle Anspruchsgebühren wurden innerhalb der vorgeschriebenen Frist entrichtet. Der vorliegende europäische Recherchenbericht wurde für alle Patentansprüche erstellt.

☐ Nur ein Teil der Anspruchsgebühren wurde innerhalb der vorgeschriebenen Frist entrichtet. Der vorliegende europäische Recherchenbericht wurde für die ersten zehn sowie für jene Patentansprüche erstellt für die Anspruchsgebühren entrichtet wurden,

nämlich Patentansprüche:

☐ Keine der Anspruchsgebühren wurde innerhalb der vorgeschriebenen Frist entrichtet. Der vorliegende europäische Recherchenbericht wurde für die ersten zehn Patentansprüche erstellt.

---

## ☒ MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung; sie enthält mehrere Erfindungen oder Gruppen von Erfindungen, nämlich:

Siehe Blatt -B-

☐ Alle weiteren Recherchengebühren wurden innerhalb der gesetzten Frist entrichtet. Der vorliegende europäische Recherchenbericht wurde für alle Patentansprüche erstellt.

☐ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind,

nämlich Patentansprüche:

☒ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen,

nämlich Patentansprüche: 1-9

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung; sie enthält mehrere Erfindungen oder Gruppen von Erfindungen, nämlich:

1. Ansprüche 1-9: Verfahren zur chemischen Dampfphasenabscheidung einer TiN-Schicht unter Verwendung einer stickstoffhaltigen Ti-Verbindung.

2. Ansprüche 10-12: Verfahren zur Abscheidung einer Mehrschicht-Struktur ohne Unterbrechung der Hochvakuum-Bedigungen zwischen den unterschiedlichen Prozessschritten